# EUROPÄISCHE PATENTSCHRIFT

(11) **EP 2 168 910 B1**
(45) Veröffentlichungstag und Bekanntmachung des Hinweises auf die Patenterteilung: **13.01.2016**
(21) Anmeldenummer: 09167236.0
(22) Anmeldetag: 05.08.2009
(51) Int. Cl.: B81C 1/00

(54) **Verfahren zur Herstellung einer mikromechanischen SiC-Struktur**
Method for making a micromechanical SiC structure
Procédé de fabrication d'un dispositif micromécanique en SiC

(30) Priorität: 29.09.2008 DE 102008042432
(43) Veröffentlichungstag der Anmeldung: 31.03.2010
(73) Patentinhaber: Robert Bosch GmbH, 70442 Stuttgart (DE)
(72) Erfinder: Behnel, Nils Rasmus, 66133 Saarbruecken (DE); Fuchs, Tino, 72076 Tuebingen (DE); Leinenbach, Christina, 66806 Ensdorf (DE)

(56) Entgegenhaltungen:
- DE-A1-102007 008 380
- CHEN L ET AL: "A silicon carbide capacitive pressure sensor for in-cylinder pressure measurement", SENSORS AND ACTUATORS A, ELSEVIER SEQUOIA S.A., LAUSANNE, CH, Bd. 145-146, 1. Juli 2008 (2008-07-01), Seiten 2-8, XP022716408, ISSN: 0924-4247, DOI: 10.1016/J.SNA.2007.09.015 [gefunden am 2008-06-12]
- CHRISTINA LEINENBACH ET AL: "A novel sacrificial layer technology based on highly selective etching of silicon-germanium in CLF3", MICRO ELECTRO MECHANICAL SYSTEMS, 2007. MEMS. IEEE 20TH INTERNATIONAL CONFERENCE ON, IEEE, PI, 1. Januar 2007 (2007-01-01), Seiten 65-68, XP031203768, ISBN: 978-1-4244-0950-1
- BEHNEL N ET AL: "A new highly selective sacrificial layer technology for SiC MEMS", SOLID-STATE SENSORS, ACTUATORS AND MICROSYSTEMS CONFERENCE, 2009. TRANSDUCERS 2009. INTERNATIONAL, IEEE, PISCATAWAY, NJ, USA, 21. Juni 2009 (2009-06-21), Seiten 740-742, XP031545799, ISBN: 978-1-4244-4190-7

## Beschreibung

### Stand der Technik

Die Erfindung betrifft ein Verfahren zur Herstellung eines Halbleiterbauelements ausgehend von einem Substrat, auf dem unter Verwendung mindestens einer strukturierten SiGe-Opferschicht und mindestens einer Funktionsschicht eine mikromechanische Struktur in einem Schichtaufbau erzeugt wird.

Derartige oberflächenmikromechanische Verfahren werden beispielsweise zur Fertigung von MEMS (Micro-Electro-Mechanical-Systems) eingesetzt, um freistehende Strukturen in der Bauteiloberfläche zu erzeugen. Voraussetzung für den Einsatz der bekannten Opferschichttechnologien ist, dass die jeweilige Opferschicht selektiv, d.h. mit ungleich höherer Ätzrate als die Funktionsschicht, geätzt wird. Die Unterätzweite bei geringer Selektivität der Opferschicht gegenüber der Funktionsschicht im jeweiligen Ätzmedium stellt den begrenzenden Faktor für die Machbarkeit dar. Insbesondere dann, wenn nicht beliebig viele Zugänge zur Opferschicht geschaffen werden können.

Die Verwendung von SiGe als Opferschichtmaterial wird bereits in der deutschen Offenlegungsschrift DE 10 2004 036 803 A1 vorgeschlagen. In dieser Druckschrift wird beschrieben, dass eine SiGe-Schicht mit Hilfe von ClF₃-Gas hochselektiv gegenüber Silizium, d.h. einem Siliziumsubstrat und/oder einer Siliziumfunktionsschicht, geätzt werden kann. Bei diesem Ätzverfahren hängt die Selektivität gegenüber Silizium vom Ge-Anteil der SiGe-Schicht ab.

Im sogenannten Bereich "Harsh Environment", d.h. in einer Umgebung, in der hohe Temperaturen oder hohe Drücke herrschen, aggressive Medien oder eine hohe Strahlungsintensität vorliegen oder starke Erschütterungen auftreten, sind siliziumbasierte Sensoren nur sehr begrenzt einsetzbar. Schutzmaßnahmen für derartige Sensoren, wie z.B. ein geeignetes Packaging oder eine Kühlung, können zu Messunsicherheiten führen und sind meist mit zu hohen Kosten für die jeweilige Anwendung verbunden. Einerseits um Gewicht und Komplexität der Aufbautechnik zu reduzieren und andererseits um die Verlässlichkeit und Effizienz der Sensoren zu steigern, wird nach neuen, robusteren Materialien für die Herstellung von Bauelementen für "Harsh Environment"-Einsatzorte gesucht, die sich mit den bewährten Verfahren der Halbleitertechnologie bearbeiten lassen.

Aus der Offenlegungsschrift DE 10 2007 008380 A1 ist ein Verfahren bekannt wonach ein SiGe-Opfermaterial durch eine porös geätzte SiC-Kappenschicht mittels CF₃ entfernt wird. In CHEN L ET AL: "A silicon carbide capacitive pressure sensor for in-cylinder pressure measurement", SENSORS AND ACTUATORS A, ELSEVIER SEQUOIA S.A., LAUSANNE, CH,Bd. 145-146, 1. Juli 2008, Seiten 2-8, wird ein SiC-Film durch Entfernen einer LTO-Schicht freigestellt.

### Offenbarung der Erfindung

Mit der vorliegenden Erfindung wird eine Möglichkeit zur Herstellung von Halbleiterbauelementen mit Verfahren der Oberflächenmikromechanik vorgeschlagen, die sich aufgrund ihrer Materialeigenschaften auch für den Einsatz im Bereich "Harsh Environment" eignen.

Erfindungsgemäß wird dazu über der SiGe-Opferschicht eine SiC-Schicht als Funktionsschicht abgeschieden und strukturiert. Dabei wird mindestens eine Zugangsöffnung zu mindestens einem SiGe-Opferschichtbereich erzeugt. Zumindest ein Teil des SiGe-Opferschichtmaterials wird dann in einem Ätzangriff über mindestens eine Zugangsöffnung in der SiC-Funktionsschicht entfernt.

Erfindungsgemäß ist zunächst erkannt worden, dass Siliziumcarbid sowohl mechanisch als auch elektrisch und thermisch stabiler ist als Silizium. Es besitzt eine größere Bandlücke als Silizium. Außerdem zeichnet es sich gegenüber Silizium durch eine höhere Elastizität, Bruchfestigkeit, Härte, Wärmeleitfähigkeit und Strahlungsresistenz aus. Des Weiteren ist erkannt worden, dass sich SiC-Schichten einfach mit Standardverfahren der Halbleitertechnologie auf einem geeigneten Trägersubstrat erzeugen und bearbeiten lassen. Schließlich ist erfindungsgemäß noch erkannt worden, dass SiC eine deutlich größere Selektivität gegenüber SiGe aufweist als Silizium, so dass sich unter Verwendung einer SiGe-Opferschicht besonders vorteilhaft auch großflächige freitragende Strukturen in einer SiC-Funktionsschicht erzeugen lassen.

Das Ätzverhalten der SiGe-Opferschicht kann in vorteilhafter Weise über deren Ge-Anteil gesteuert werden. Dabei ist zu beachten, dass der Schmelzpunkt von SiGe vom Ge-Anteil abhängt und mit zunehmendem Ge-Anteil abnimmt. Die jeweiligen Anteile von Si und Ge in einer SiGe-Opferschicht lassen sich wie folgt beschreiben: Si₁₋ₓGeₓ. Der Wertebereich für x ist von 0 bis 1.

Wie bereits in Verbindung mit der deutschen Offenlegungsschrift DE 10 2004 036 803 A1 erwähnt, weist SiGe auch gegenüber Silizium eine hohe Selektivität auf. Deshalb kann die SiGe-Opferschicht auch auf einer Si-Schicht oder einem Si-Substrat abgeschieden werden, um mit Hilfe des erfindungsgemäßen Verfahrens einen definierten Hohlraum unter der SiC-Funktionsschicht zu erzeugen. In den Fällen, in denen aber eine besonders hohe Unterätzrate zur Realisierung der gewünschten Struktur in der Funktionsschicht erforderlich ist, erweist es sich als vorteilhaft, die SiGe-Opferschicht auf bzw. über einer ersten SiC-Schicht abzuscheiden, die dann genauso wie die SiC-Funktionsschicht als Ätzstoppgrenze beim Entfernen des Opferschichtmaterials fungiert.

Ein besonderer Vorteil des erfindungsgemäßen Verfahrens ist, dass sich sowohl die SiGe-Opferschicht als auch die SiC-Funktionsschicht einfach mit Standardverfahren der Halbleitertechnologie erzeugen und bearbeiten lassen. So können beispielsweise beide Materialien in der gewünschten Zusammensetzung einfach in einem CVD (chemical vapor deposition)-Verfahren auf einer Oberfläche abgeschieden werden. Die SiGe-Opferschicht wird vorteilhafterweise in einem plasmaunterstützten fluorbasierten Ätzverfahren strukturiert. Nach dem Aufbringen der SiC-Funktionsschicht wird das SiGe-Opferschichtmaterial vorteilhafterweise trockenchemisch mittels ClF₃-, BrF₃- und/oder XeF₂-Gas entfernt. Bei Verwendung von Chlortrifluorid-Gas (ClF₃) beträgt die Selektivität von SiGe gegenüber SiC 1.000.000:1, was die bekannten Werte der Selektivität von SiGe gegenüber Si um ein Vielfaches übersteigt. Dadurch kann die Unterätzweite bzw. die Unterätzrate wesentlich gesteigert werden, ohne einen Ätzangriff der SiC-Funktionsschicht zu bewirken. So können beispielsweise für die Herstellung von Drucksensormembranen Unterätzweiten von mehr als 250µm angestrebt werden, was die Unterätzweiten konventioneller Opferschichttechnologien um mehrere Größenordnungen übersteigt. Dadurch kann die Anzahl der Zugangsöffnungen für das Ätzgas reduziert werden und deren Anordnung auf einen kleinen Bereich beschränkt werden. Dies erweist sich insbesondere beim Unterätzen von Membranen als vorteilhaft, da hier die Anordnung von vergleichsweise wenigen Zugangsöffnungen im Randbereich der Membran ausreicht. Dementsprechend ist das Verschließen dieser Zugangsöffnungen nach dem Unterätzen relativ unaufwendig.

Das erfindungsgemäße Verfahren eignet sich deshalb besonders für die Herstellung von Halbleiterbauelementen mit einer Membranstruktur, insbesondere zur Herstellung von Drucksensoren, Schallwandlern, Temperatursensoren, Inertialsensoren und Sensorverkappungen.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die dem unabhängigen Patentanspruch 1 nachgeordneten Patentansprüche und andererseits auf die nachfolgende Beschreibung eines Ausführungsbeispiels der Erfindung anhand der Zeichnung verwiesen.

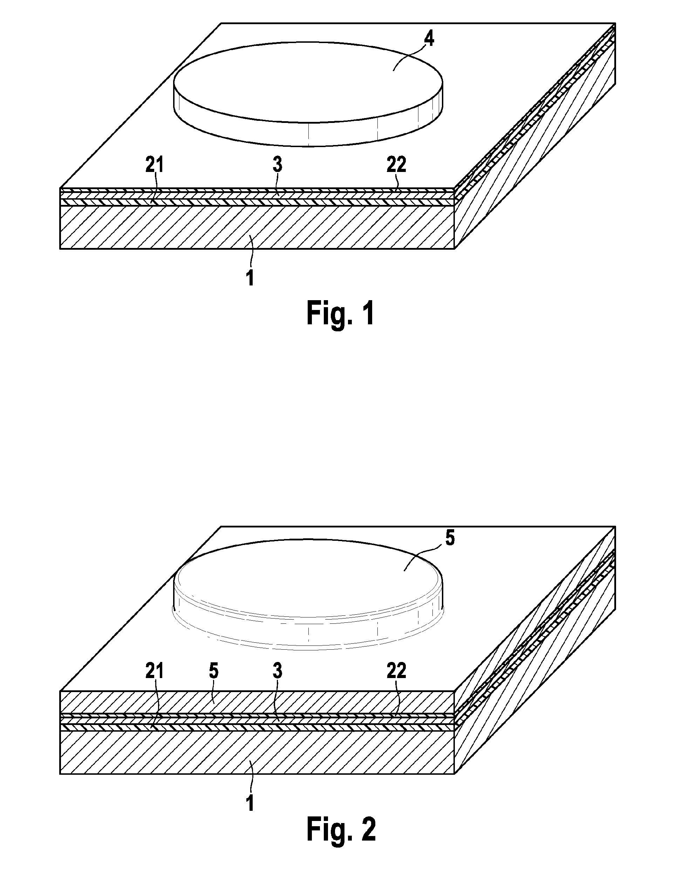

Die **Figuren 1 bis 5** zeigen jeweils eine perspektivische Ansicht eines Halbleiterbauelements in verschiedenen Stadien des erfindungsgemäßen Verfahrens.

### Ausführungsform der Erfindung

In **Fig. 1** ist ein Halbleitersubstrat 1 mit einem Schichtaufbau dargestellt. Dieser umfasst eine erste Isolationsschicht 21 zur elektrischen Isolation des Halbleitersubstrats 1 gegen elektrische Komponenten in darauffolgenden Schichten. Über der ersten Isolationsschicht 21 wurde eine erste SiC-Schicht 3 abgeschieden und strukturiert, um die Gegenelektrode eines Messkondensators und deren Zuleitungen zu realisieren. Darüber befindet sich eine zweite Isolationsschicht 22. Fig. 1 zeigt den Schichtaufbau, nachdem eine SiGe-Opferschicht 4 auf der zweiten Isolationsschicht 22 abgeschieden und entsprechend der Form und den Abmessungen einer noch zu erzeugenden Membran bzw. eines Hohlraums unter dieser Membran strukturiert worden ist. Die Strukturierung der SiGe-Opferschicht 4 kann mittels plasmaunterstützten fluorbasierten Ätzverfahren erfolgt sein oder auch plasmalos mittels Chlortrifluorid-Gas.

Erfindungsgemäß wurde über der strukturierten SiGe-Opferschicht 4 eine SiC-Funktionsschicht 5 abgeschieden, was in **Fig. 2** dargestellt ist.

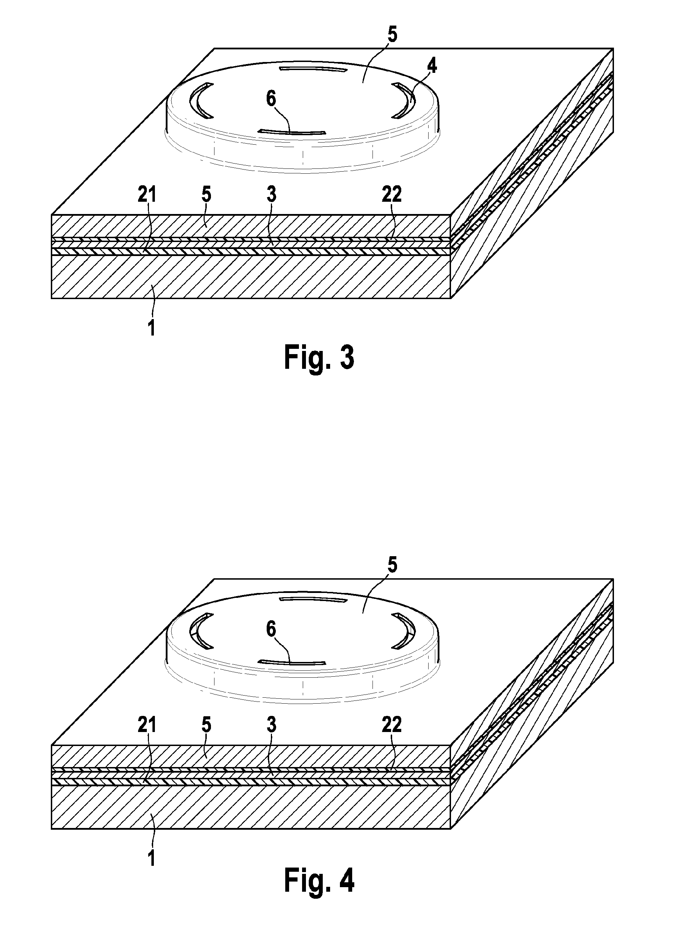

Um einen Hohlraum unter der SiC-Funktionsschicht 5 zu erzeugen und so eine Membran in der SiC-Funktionsschicht 5 auszubilden, muss nun das SiGe-Opferschichtmaterial 4 entfernt werden. Dazu wurden im hier dargestellten Ausführungsbeispiel durch Plasmastrukturierung der SiC-Funktionsschicht 5 Ätzzugänge 6 erzeugt. **Fig. 3** veranschaulicht die Anordnung der Ätzzugänge 6, die aufgrund der voranstehend beschriebenen hohen Selektivität von SiGe gegenüber SiC nur im Randbereich der zu erzeugenden Membran liegen.

In einem plasmalosen trockenchemischen Ätzangriff über die Ätzzugänge 6 wurde nun das SiGe-Opferschichtmaterial entfernt. Dabei entstand eine freitragende SiC-Membranstruktur 7, wie sie in **Fig. 4** dargestellt ist.

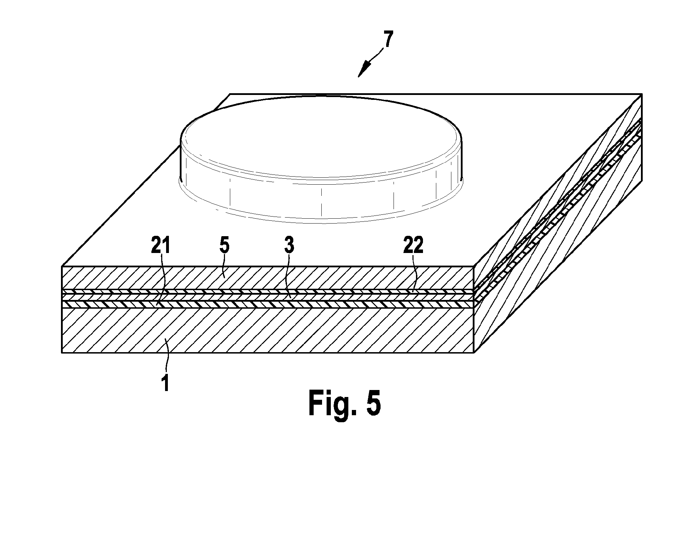

**Fig. 5** zeigt das Halbleiterbauelement mit der Membranstruktur 7, nach dem Verschließen der Ätzzugänge 6. Aufgrund ihrer geringen Größe konnte dazu ein PECVD-Verfahren mit nichtkonformer Abscheidecharakteristik verwendet werden.

## Patentansprüche

1. Verfahren zur Herstellung eines Halbleiterbauelements ausgehend von einem Substrat (1), auf dem unter Verwendung mindestens einer strukturierten SiGe-Opferschicht (4) und mindestens einer SiC-Schicht (5) als Funktionsschicht (5) eine mikromechanische Struktur (7) in einem Schichtaufbau erzeugt wird, indem
- die SiC-Funktionsschicht (5) über der SiGe-Opferschicht (4) abgeschieden und strukturiert wird, wobei mindestens eine Zugangsöffnung (6) zu mindestens einem SiGe-Opferschichtbereich (4) erzeugt wird, und
- zumindest ein Teil des SiGe-Opferschichtmaterials in einem Ätzangriff über die mindestens eine Zugangsöffnung (6) in der SiC-Funktionsschicht (5) entfernt wird,
**dadurch gekennzeichnet, dass** die SiGe-Opferschicht (4) über einer ersten SiC-Schicht (3) abgeschieden wird und mittels einer Unterätzung beim Ätzangriff ein Hohlraum unter der SiC-Funktionsschicht (5) erzeugt wird.

2. Verfahren nach Anspruch 1, **dadurch gekennzeichnet, dass** die SiGe-Opferschicht auf der ersten SiC-Schicht abgeschieden wird, wobei die erste SiC-Schicht als Ätzstoppschicht beim Entfernen des SiGe-Opferschichtmaterials fungiert.

3. Verfahren nach einem der Ansprüche 1 oder 2, **dadurch gekennzeichnet, dass** die zumindest eine Zugangsöffnung (6) nach der Entfernung des SiGe-Opferschichtmaterials verschlossen wird.

4. Verfahren nach einem der Ansprüche 1 bis 3, **dadurch gekennzeichnet, dass** durch den Hohlraum in der SiC-Funktionsschicht (5) eine Membran ausgebildet wird, wobei die Zugangsöffnungen (6) im Randbereich der erzeugten Membran liegen.

5. Verfahren nach einem der vorhergehenden Ansprüche, **dadurch gekennzeichnet, dass** das Ätzverhalten der SiGe-Opferschicht (4) über deren Ge-Anteil gesteuert wird.

6. Verfahren nach einem der vorhergehenden Ansprüche, **dadurch gekennzeichnet, dass** die erste SiC-Schicht (3) als vergrabene Elektrode konfiguriert wird.

7. Verfahren nach einem der vorhergehenden Ansprüche, **dadurch gekennzeichnet, dass** die SiGe-Opferschicht (4) in einem plasmaunterstützten fluorbasierten Ätzverfahren strukturiert wird.

8. Verfahren nach einem der vorhergehenden Ansprüche, **dadurch gekennzeichnet, dass** das SiGe-Opferschichtmaterial trockenchemisch mittels ClF₃-, BrF₃- und/oder XeF₂-Gas entfernt wird.

9. Verfahren nach einem der vorhergehenden Ansprüche zur Herstellung von Halbleiterbauelementen mit einer Membranstruktur, insbesondere zur Herstellung von Drucksensoren, Schallwandlern, Temperatursensoren, Inertialsensoren und Sensorverkappungen.

## Claims

1. Method for producing a semiconductor component proceeding from a substrate (1), on which a micromechanical structure (7) in a layer construction is produced using at least one patterned SiGe sacrificial layer (4) and at least one SiC layer (5) as functional layer (5), by a procedure in which
- the SiC functional layer (5) is deposited above the SiGe sacrificial layer (4) and is patterned, at least one access opening (6) to at least one SiGe sacrificial layer region (4) being produced, and
- at least part of the SiGe sacrificial layer material is removed in an etching attack via the at least one access opening (6) in the SiC functional layer (5),
**characterized in that** the SiGe sacrificial layer (4) is deposited above a first SiC layer (3) and a cavity is produced below the SiC functional layer (5) by means of undercutting during the etching attack.

2. Method according to Claim 1, **characterized in that** the SiGe sacrificial layer is deposited on the first SiC layer, the first SiC layer functioning as an etch stop layer during the removal of the SiGe sacrificial layer material.

3. Method according to either of Claims 1 and 2, **characterized in that** the at least one access opening (6) is closed after the removal of the SiGe sacrificial layer material.

4. Method according to any of Claims 1 to 3, **characterized in that** a membrane is formed through the cavity in the SiC functional layer (5), the access openings (6) lying in the edge region of the membrane produced.

5. Method according to any of the preceding claims, **characterized in that** the etching behaviour of the SiGe sacrificial layer (4) is controlled via the Ge proportion thereof.

6. Method according to any of the preceding claims, **characterized in that** the first SiC layer (3) is configured as a buried electrode.

7. Method according to any of the preceding claims, **characterized in that** the SiGe sacrificial layer (4) is patterned in a plasma-enhanced fluorine-based etching method.

8. Method according to any of the preceding claims, **characterized in that** the SiGe sacrificial layer material is removed wet-chemically by means of ClF₃, BrF₃ and/or XeF₂ gas.

9. Method according to any of the preceding claims for producing semiconductor components comprising a membrane structure, in particular for producing pressure sensors, sound transducers, temperature sensors, inertial sensors and sensor cappings.

## Revendications

1. Procédé de fabrication d'un composant semi-conducteur à partir d'un substrat (1) sur lequel une structure micromécanique (7) est formée dans la structure stratifiée en recourant à au moins une couche sacrifiée (4) et structurée en SiGe et au moins une couche (5) de SiC comme couche fonctionnelle (5),
en déposant la couche fonctionnelle (5) de SiC au-dessus de la couche sacrifiée (4) de SiGe et en la structurant, au moins une ouverture (6) donnant accès à au moins une partie (4) de la couche sacrifiée de SiGe étant formée et
en enlevant au moins une partie du matériau de la couche sacrifiée de SiGe dans une attaque par gravure de la couche fonctionnelle (5) de SiC au-dessus de la ou des ouvertures d'accès (6),
**caractérisé en ce que**
la couche sacrifiée (4) de SiGe est déposée au-dessus d'une première couche (3) de SiC et une cavité est formée en dessous de la couche (5) fonctionnelle de SiC au moyen d'une gravure inférieure pendant l'attaque par gravure.

2. Procédé selon la revendication 1, **caractérisé en ce que** la couche sacrifiée de SiGe est déposée sur la première couche de SiC, la première couche de SiC jouant le rôle d'une couche d'arrêt de gravure lors de l'enlèvement du matériau de la couche sacrifiée de SiGe.

3. Procédé selon l'une des revendications 1 ou 2, **caractérisé en ce que** la ou les ouvertures d'accès (6) sont fermées après l'enlèvement du matériau de la couche sacrifiée de SiGe.

4. Procédé selon l'une des revendications 1 à 3, **caractérisé en ce qu'**une membrane est formée dans la couche fonctionnelle (5) de SiC à travers la cavité, les ouvertures d'accès (6) étant situées sur la bordure de la membrane ainsi formée.

5. Procédé selon l'une des revendications précédentes, **caractérisé en ce que** le comportement de la couche sacrifiée (4) de SiGe à la gravure est contrôlé par l'intermédiaire de sa teneur en Ge.

6. Procédé selon l'une des revendications précédentes, **caractérisé en ce que** la première couche de SiC (3) est configurée comme électrode enterrée.

7. Procédé selon l'une des revendications précédentes, **caractérisé en ce que** la couche sacrifiée (4) de SiGe est structurée dans une opération de gravure à base de fluor soutenue par plasma.

8. Procédé selon l'une des revendications précédentes, **caractérisé en ce que** le matériau de la couche sacrifiée de SiGe est enlevé par voie chimique sèche en recourant à du LlF₃, du BrF₃ et/ou du XeF₂ gazeux.

9. Procédé selon l'une des revendications précédentes, pour la fabrication de composants semiconducteurs à structure de membrane, en particulier pour la fabrication de capteurs de pression, de convertisseurs acoustiques, de capteurs de température, de capteurs inertiels et d'encapsulations de capteurs.
